# EUROPEAN PATENT SPECIFICATION

(11) **EP 4 679 712 B1**
(45) Date of publication and mention of the grant of the patent: **15.04.2026**
(21) Application number: 24187244.9
(22) Date of filing: 08.07.2024
(51) Int. Cl.: H03K 17/06, H02H 3/087, H03K 17/082

(54) **ELECTRONIC FUSE DRIVER INTERFACE**
ELEKTRONISCHE SICHERUNGSTREIBERSCHNITTSTELLE
INTERFACE DE COMMANDE DE FUSIBLE ÉLECTRONIQUE

(43) Date of publication of application: 14.01.2026
(73) Proprietor: Aptiv Technologies AG, 8200 Schaffhausen (CH)
(72) Inventor: TYPROWICZ, Wojciech, 8200 Schaffhausen (CH); TOKARZ, Krzysztof, 8200 Schaffhausen (CH); HEINRICH, Markus, 8200 Schaffhausen (CH); DEBSKI, Janusz, 8200 Schaffhausen (CH)
(74) Representative: Lewis Silkin LLP

(56) References cited:
- WO-A1-2014/077266
- JP-A- 2009 010 477

## Description

### Field

The present disclosure relates to an electronic fuse driver interface. The present disclosure particularly concerns circuitry for an interface between the driver and the electronic fuse, which ensures that protection of a test load by the electronic fuse is performed under loss of ground conditions. The present disclosure further relates to a drive module comprising the fuse driver and the interface, and a test module comprising the drive module and the electronic fuse.

### Background

Electronic fuses, also referred to as 'e-fuses', react to over-currents by switching off an active component, typically a transistor, blocking current flow through the fuse. E-fuses react far more quickly, and more sensitively, than thermal fuses designed to melt when an electric current passing through a fuse element exceeds a predetermined level. E-fuses can also be reset by switching on the active component, whereas it is necessary to replace a thermal fuse after it has melted.

In the case of an e-fuse which uses a metal-oxide-semiconductor field-effect transistor (MOSFET) as its active component, high speed switching is performed by control circuitry that drives the gate of the MOSFET. The control circuitry reacts to an over-current situation, such as that caused by short-circuiting a load to a ground voltage, to output a voltage to the gate that controls the MOSFET to prevent excessive current flow and damage to the load. A push-pull driver circuit is typically selected to drive the gate voltage, based on a complementary pair of transistors. One of the pair of transistors pulls the MOSFET gate towards ground when a low gate voltage is required, and the other of the pair of transistors pulls the MOSFET gate towards a power source voltage when a high gate voltage is required. A push-pull driver is highly efficient as it is able to drive current in two directions, either sourcing current towards the gate or sinking current away from the gate towards ground. A push-pull driver is also low-cost.

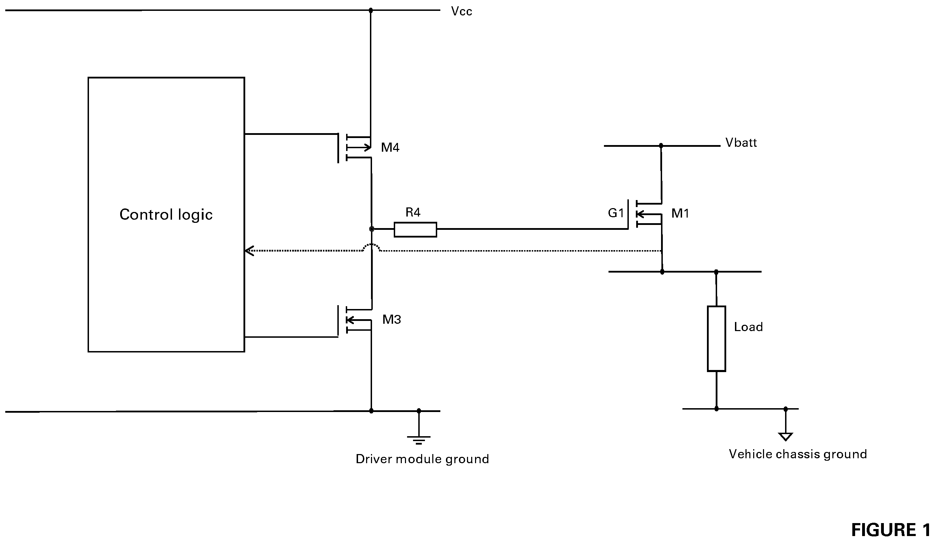

Figure 1 shows an example of a typical push-pull driver for driving the gate, G1, of an e-fuse MOSFET, M1. The e-fuse is employed, in the illustrated example, to protect the electrical load of a vehicle in the event of erroneous voltage between the vehicle's battery and the vehicle's chassis ground, although the principles of operation of the e-fuse also apply in other scenarios. The push-pull driver uses a combination of a p-channel MOSFET, M4, and an n-channel MOSFET, M3, the gates of each of which are driven by control logic. The control circuit is configured to determine an overcurrent between the drain and source of M1 via sensing logic (simplified, and represented by a dashed line). The source of M4 is connected to a power source voltage Vcc, while the source of M3 is connected to driver ground. The output of the driver is connected to gate G1 via a resistor R4, to limit current from the driver when M1 is to be driven low.

The representation shown in Figure 1 is simplified from a practical implementation, to facilitate explanation of its operating principle. Additional components such as resistors and Zener diodes are typically employed in order to optimize and stabilize performance.

In the example of Figure 1, the e-fuse MOSFET, M1, is an n-channel MOSFET, having its drain connected to a vehicle battery supply Vbatt. The source of M1 is connected to chassis ground through the vehicle's electrical load. In this configuration, M1 acts as a fuse to prevent excessive supply of current from the battery to the vehicle's load. If such excessive supply is detected, G1 is driven low, in order to switch off M1 and prevent supply of current to the car's load. In normal operation, the G1 is driven high so that current is passed through M1.

The push-pull driver has a disadvantage in that it is not able to produce a gate voltage which is below the ground voltage of the driver circuit. As a result of this, if vehicle's chassis ground is, for any reason, different from the driver's ground voltage, a situation may arise in which a low-state voltage applied by the driver to G1 is not sufficient to turn M1 off. A floating driver ground will cause a low state G1 voltage to be similarly floating, such that the gate-source voltage exceeds M1's threshold voltage.

A floating driver ground, such that the chassis ground is outside of the supply range of the driver, is referred to in the present disclosure as a "loss of ground". A test load is vulnerable to excessive current flow and power dissipation in such circumstances, if erroneous operation or a broken connection at the vehicle causes the test load to be shorted to ground.

In automotive test environments, it is necessary to test how the vehicle responds to loss of ground events, to ensure that the response prevents damage to vehicle components. If a vehicle's e-fuse is configured in the manner shown in Figure 1, it is not possible for a loss of ground test to be passed, since it cannot be determined with certainty that the gate-source voltage of G1 will always be low enough to protect the vehicle's components, even if the driver circuitry is outputting a low drive state to the gate of M1.

The present disclosure describes circuitry for enhancing an e-fuse driver circuit, which enables correct operation of the e-fuse in loss of ground events. In embodiments, interface circuitry is arranged between a push-pull gate driver and the gate of a driven e-fuse MOSFET to keep the MOSFET switched off in loss of ground conditions, protecting loads which are connected to the MOSFET. The resulting driving of the e-fuse is cost-effective, achieved using a relatively small number of components. In automative applications, the driver set out in the present disclosure is such that it possible to test functionality reliably in loss of ground events, so that compliant vehicles can receive a positive test result.
International Patent Application WO 2014/077266 discloses a power supply control device for preventing damage to a FET due to a floating ground and reverse polarity connection at the power supply.
Japanese Patent Application JP 2009/010477 discloses a MOSFET protection circuit for short-circuiting the gate and source of a MOSFET if the gate of the MOSFET is floating.

### Summary

According to a first aspect, there is provided an electronic fuse driver interface comprising a circuit arranged to couple to the driver, the electronic fuse, and a test load, and comprising a switch for selectively coupling a control input of the electronic fuse to a ground of the test load, and a resistor network between the ground of the test load and a ground of the driver, wherein the switch is connected to the resistor network so as to switch the control input such that the electronic fuse blocks current between a test supply voltage and the test load if the driver ground voltage is above the test load ground voltage, the interface further comprising a diode connected between an intermediate node of the resistor network and the test supply voltage to provide a path from the ground of the test load and the test supply voltage if the test supply voltage is below the ground of the test load.

In this way, the interface enables testing of a loss of ground event at the driver, in which the driver ground is floating and rises above the ground of the test load. The interface ensures that a conventional driver can be used with a conventional electronic fuse to perform the loss of ground test, requiring minimal circuit components. The interface is also configured to enable reverse polarity testing to be performed, in which operation is to be verified in the event that a user erroneously connects the terminals of the test load power supply the wrong around.

In embodiments, the switch is a transistor, connected between the control input of the electronic fuse and the test load.

In embodiments, the input to the transistor is configured such that it is driven above a threshold voltage, if the driver ground voltage is above the test load ground voltage, to provide a current path between the control input of the electronic fuse and the test load. In this way, the switch can be controlled by current at the input to the transistor, arising from a voltage difference between the driver ground and the test load ground, without the need for generation of a dedicated control signal in a loss of ground event.

In embodiments, the input to the transistor is connected to a further intermediate node of a resistor network between the driver ground and the test load ground.

In embodiments, the interface further comprises a diode between the driver ground and the resistor network so as restrict current flow through the resistor network in the direction from the test load ground to the driver ground. In this way, reverse polarity of the test load, and a high voltage at the test load ground, does not damage the driver.

According to a second aspect, there is provided a drive module for an electronic fuse, comprising a driver, and the above interface, wherein the driver comprises a complementary pair of MOSFETs in a push-pull transistor configuration, having a common drain connection, and a controller for controlling a driver output voltage at the common drain connection in dependence upon current through the electronic fuse, wherein the driver output is connected to the control input of the electronic fuse, and the collector of the switch of the interface.

In embodiments, the driver is an application-specific integrated circuit, ASIC, which is a design which facilitates physical handling and connection to a test environment.

In embodiments, the driver output is for driving an electronic fuse connected between an automotive battery supply and an automotive load, wherein the electronic fuse ground is a chassis ground. In this way, automotive test requirements can be achieved with the driver.

According to a third aspect, there is provided a test module comprising the above drive module and the electronic fuse, wherein the electronic fuse is a MOSFET, wherein the control input is the gate of the MOSFET, the drain of the MOSFET is connected to the test supply voltage, and the source of the MOSFET is connected to the test load. In this way, the testing and e-fuse protection of the MOSFET can be achieved via an integrated module, facilitating interchange of different test loads to the test module.

In embodiments, the MOSFET of the electronic fuse is connected to a further MOSFET in a back-to-back configuration, and a control input of the further MOSFET is connected to the driver and the switch of the interface. In this way, reverse current through the MOSFET can be blocked in two directions.

### Brief Description of Drawings

Illustrative embodiments will now be described with reference to the drawings in which:
Figure 1 illustrates a typical push-pull driver for driving the gate of an e-fuse MOSFET;
Figure 2 illustrates an example of an e-fuse driver interface;
Figure 3 illustrates a further example of an e-fuse driver interface; and
Figure 4 illustrates an e-fuse driver interface according to an embodiment.

### Detailed Description

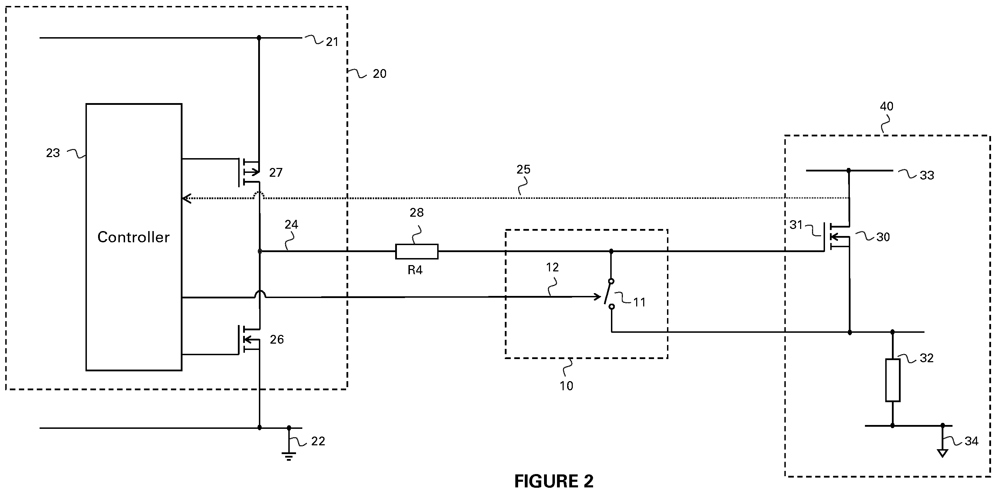

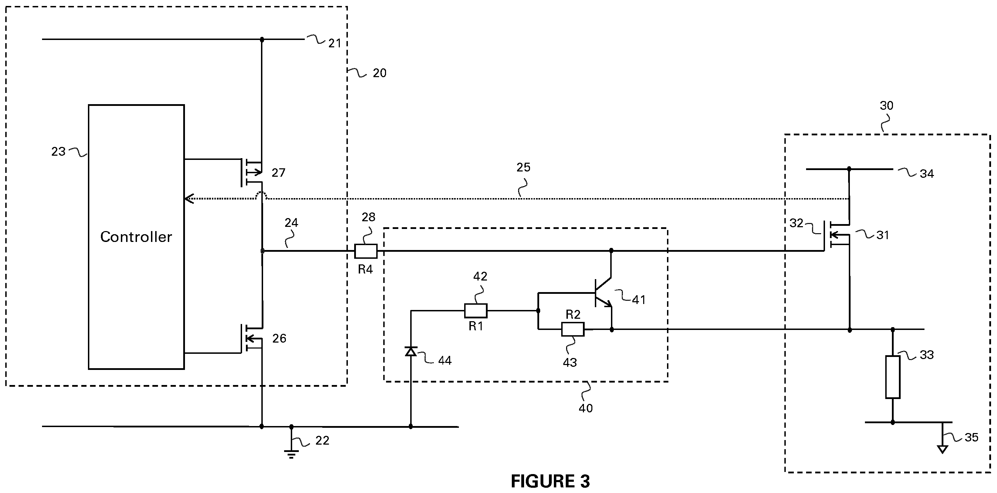

Principles of operation of embodiments of the present disclosure are described with reference to the comparative examples illustrated in Figures 2 and 3.
Figure 2 illustrates a first comparative example of the configuration of an e-fuse driver interface 10.

The interface 10 comprises circuitry which is arranged between a driver 20 and a test environment 30, and specifically the e-fuse 31. The driver 20 is of similar type to that shown in Figure 1, with a push-pull driver comprising two complementary transistors 26, 27, operating under the control of a controller 23, to output a drive signal 24 through a limiting resistor (R4) 28. The e-fuse 31 is operable to block current flow between a test voltage supply 34 and a test load 33. The test load 33 represents one or more components of a vehicle, with the test voltage supply 34 corresponding to a battery in the vehicle, and a ground voltage of the test load 33 corresponding to a vehicle chassis ground 35.

The driver 20 outputs the control signal 24 to the control input 32 of the e-fuse 31 to turn the e-fuse 31 on or off. If the e-fuse 31 is on, current flows from the test voltage supply 34 to chassis ground 35 through the test load 33. If the e-fuse 31 is off, current flow is blocked by the e-fuse 31, protecting the test load 33. The control signal 24 output by the driver 20 is determined by a controller 23 at the driver 20, responding to a sensed or calculated electrical characteristic of the test environment 30, such as the level of the test voltage supply 34, or a current level. Such operation is represented in Figure 2 by a feedback signal 25 from the test environment 30 to the driver 20, shown as a dotted line.

The control signal 24 output by the driver 20 is a voltage which is measured with reference to a driver ground voltage 22. If the driver ground 22 were connected to the chassis ground 35, such that the test environment 30 and driver 20 would have a common ground, a control voltage 24 output by the driver 20 would be defined in the same electrical frame of reference as that which exists at the test environment 30. In this configuration, referred to herein as 'normal conditions', the e-fuse 31 would be controlled correctly.

However, it is necessary to test operation of the e-fuse 31 to comply with particular test requirements associated with the test load 33. For example, if the test load 33 is an automative test load, it is necessary to test whether the load 33 continues to be protected by the e-fuse 31 in the event that the driver 20 and the test load 33 do not share a common ground, due to, for example, a disconnection or short circuit at the driver 20. Such a scenario is referred to herein as a 'loss of ground', and occurs when the ground of the driver 22 is floating with respect to the chassis ground 35.

As described above with respect to Figure 1, where there is a loss of ground, the control signal 24 output by the driver 20 may be too high to cause the e-fuse 31 to be switched off if there is an overcurrent at the test load 33, even if the control signal is a low state signal determined by the controller 23 of the driver 20. The interface 10 aims to address this problem, and comprises a switch 11 for selectively coupling the control input 32 of the e-fuse 31 to chassis ground 35, in response to a loss of ground scenario at the driver 20. By doing so, the e-fuse 31 is switched off, by pulling the gate voltage below a level which exceeds the gate-source threshold voltage of the e-fuse MOSFET 31. This protects the test load 33 against potential damage caused by overcurrents, such as excessive power dissipation, by blocking current flow between the test voltage supply 34 and the test load 33. The switch 11 is any suitable switch, such as a relay or transistor, and is represented as a generalisation in Figure 2.

In the illustration of Figure 2, the loss of ground scenario is represented as a functional control input 12 to the switch 11. The input 12 may be provided by the controller 23 based on a comparison of driver ground 22 and chassis ground 35 voltages, or alternatively, derivation of a voltage associated with current flow between the driver ground 24 and the chassis ground 35 due to a difference between them. An example of such current flow is described in more detail with reference to Figure 3.

The loss of ground event is simulated by appropriate configuration of the driver ground 20 and the chassis ground as part of a test scenario, and the operation of interface circuit 30 is verified in response to the occurrence of the test scenario.

Figure 3 illustrates a second comparative example of an e-fuse driver interface 40. The principle of operation of the interface 40 of the second example is the same as that of the first example, and like reference signs are used to represent like components.

The interface 40 of the second example operates in the context of a test environment 30 in which the e-fuse 31 is a MOSFET, having its gate 32 as the control input. The driver 20 is a push-pull circuit, of a type described above with reference to Figure 1, and the control signal 24 output by the driver 20 is coupled to the gate 32 of the MOSFET 31 via limiting resistor 28. The MOSFET 31 is a n-channel MOSFET, having its drain connected to the test voltage supply 34, and its source connected to the test load 33.

The switch of the interface 40 is illustrated as a bipolar transistor 41, having its collector connected to the MOSFET gate 32, and its emitter connected to the test load 33. The switch 41 is, alternatively, a switch or relay or a transistor which is not a bipolar transistor, such as the switch 11 shown in Figure 2, connected between the input to e-fuse 31 and the test load 33, and controlled by an input 12. The operation of the switch 41 is controlled by the base-emitter voltage of the bipolar transistor. If the base-emitter voltage exceeds a threshold, the bipolar transistor 41 switches on, and pulls the MOSFET gate voltage 32 down a low state below the threshold by connecting it to chassis ground 35 through the test load 33. In doing so, the MOSFET 32 is switched off, blocking current between the test voltage supply 34 and the test load 33.

The base of the bipolar transistor 41 is arranged so that the base-emitter voltage exceeds the threshold when there is a loss of ground event. In the configuration of Figure 3, this is achieved by a resistor network 42, 43, configured between driver ground 22 and chassis ground 35. When the driver ground 22 exceeds chassis ground 35, current flows through the resistor network 42, 43. By appropriate selection of resistor values R1, R2, the base-emitter voltage can be controlled such that it exceeds chassis ground 35 by an amount sufficient to turn the bipolar transistor 41 on. A diode 44 between the resistor network 42, 43 and driver ground 22 ensures that current flow is only in the direction from the driver ground 22 to the chassis ground 35, such that the bipolar transistor 41 is not damaged by a negative base-emitter voltage if the driver ground 22 falls below the chassis ground 35. Further the driver 20 is not damaged by a high chassis ground 35 in the event that the test environment 30 is wrongly configured with the power supply connections of the test load 32 reversed.

The configuration of the bipolar transistor 41 is such that it is not necessary to provide a dedicated input to the base from the controller 23, as the current arising from the loss of ground event, and the flow from the driver ground 22 to the chassis ground 35, is itself the cause of the base-emitter voltage exceeding the threshold voltage of the transistor 41.

In normal conditions, in which chassis ground 35 and driver ground 22 are equal, the absence of current through the resistor network 42, 43 means that the bipolar transistor 41 is switched off, such that the control input 32 to the MOSFET is determined by the control signal 24 output by the driver 20.

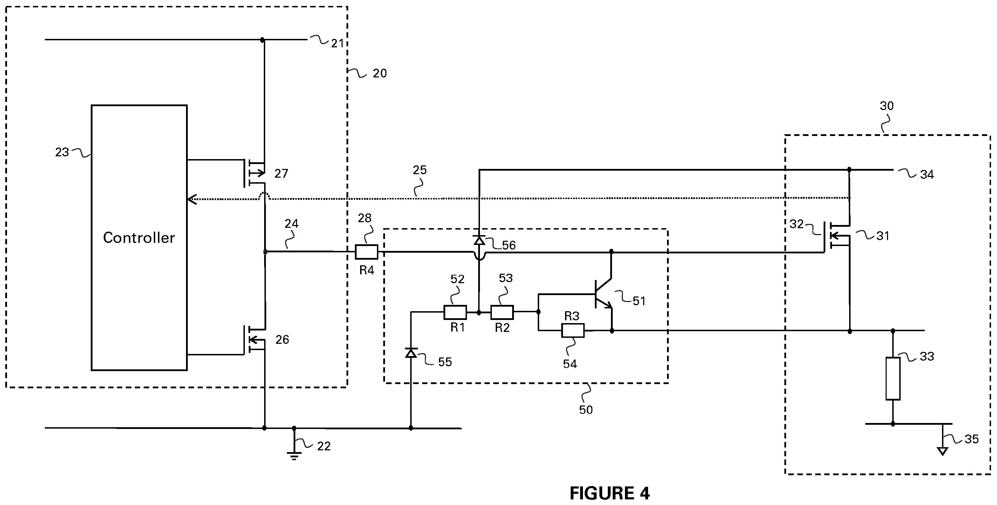

Figure 4 illustrates an e-fuse driver interface 50 according to an embodiment. The principle of operation of the interface 50 of the embodiment is the same as that of the first and second comparative examples, and like reference signs are used to represent like components.

The interface 50 is configured such that in addition to enabling loss of ground testing, it is possible to test the operation that occurs when there is a reverse polarity event across the test load 33. A reverse polarity event typically occurs when a user erroneously connects a vehicle's battery with the terminals reversed, such that the vehicle battery connection 34 is the chassis ground, and the chassis ground connection 35 is a positive battery voltage. Typically, the voltage at terminal 35 exceeds the voltage at terminal 34 by 5V in a reverse polarity event
On occurrence of a reverse polarity event, the interface 50 is configured such that the e-fuse MOSFET 31 is on, with a gate-source voltage that exceeds the threshold voltage of the MOSFET 31. In order to achieve this, a high voltage control signal 24 is output by the driver 20, and transistor 51 is deactivated so that the control voltage 24 is supplied to the control input 32 of the MOSFET 31 without being pulled towards chassis ground.

The reverse polarity event may not necessarily cause damage to the vehicle's components, particularly where diodes and the like are incorporated into the component circuitry to block current flowing incorrectly, and therefore it is acceptable for current to flow through the test load in a reverse polarity event. If the e-fuse MOSFET 31 is on, an acceptable current flows through the MOSFET 31, since the MOSFET 31 can pass current in either direction between the drain and source when the gate-source voltage exceeds a threshold.

If, however, the e-fuse MOSFET 31 were to be switched off in a reverse polarity event, reverse current would flow through the forward-biased drain-source parasitic body diode, rather than through the drain-source channel. This current causes damage to the MOSFET 31, due to the high power dissipation and overheating that occurs. Typically, a MOSFET has a relatively low reverse current rating, above which such damage will occur.

Therefore, to ensure that e-fuse MOSFET 31 remains on, a high voltage control signal 24 is output by the controller 23, in response to a feedback signal 25 indicating the presence of a reverse polarity event. The control signal 24 is high enough that the gate-source threshold of the MOSFET 31 is exceeded. The reverse polarity event is simulated in a test scenario by application of appropriate voltages to terminals 34 and 35.

In embodiments, and in comparison with the interface 40 of Figure 3, the interface 50 includes a diode 56 between the resistor network 53, 54 at the base of the transistor 51 and the reverse-polarity battery supply 34. As such, a path exists between the reverse-polarity chassis ground 35, the test load 33, resistor 54, resistor 53 and diode 56 to the reverse-polarity battery supply 34.

On occurrence of a reverse polarity event, the presence of this path through diode 56 ensures that the source voltage is lowered by the voltage drop across the test load 33. The drop in the source voltage enables the gate voltage to exceed the source voltage by the threshold required to turn on the MOSFET 31, without the need for the control output 24 from the driver 20 to be different from that used in conjunction with the interface of the first or second comparative examples. Consequently, interface circuit 50 enables both a reverse polarity test and a loss of ground test to be performed with a conventional push-pull e-fuse driver.

The values of resistors 52 (R1), 53 (R2) and 54 (R3) are selected such that both loss of ground and reverse polarity tests can be performed. Resistors 53 and 54 are selected in order to achieve the required drop in voltage across the test load 33, while each of resistors 52, 53 and 54 are selected to configure the base voltage of the transistor 51 to turn it on in response to a loss of ground event.

As described above, the embodiments of the present disclosure provide an interface which enables an e-fuse MOSFET driver to be used in a manner in which conventional limitations are addressed, particularly the inability of the gate voltage of the MOSFET to go below the ground driver ground voltage, which would otherwise prevent particular compliance tests being performed on a test load protected by the e-fuse. Although the embodiments are described in connection with automotive contexts, this is simply by way of example, with loss of ground and reverse polarity scenarios applying to a variety of different test loads. References herein to 'chassis ground' are to be interpreted in the context of the chassis or housing of a device or system within which the test load is installed, and the term 'test load ground' and its derivatives is used herein as a load-agnostic terminology.

In a modification of the embodiments described above, the e-fuse MOSFET 31 may be replaced by a pair of complementary MOSFETs arranged in series in a 'back-to-back' configuration between the test load and the supply voltage. Both gate voltages are connected to the controller of the driver. As is known in the art, this configuration, in which the sources of the MOSFETs are connected, provides protection against reverse current by blocking current in both directions through the MOSFET pair. In contrast, a single MOSFET can only block current in one direction when the gate-source voltage is below the threshold. Consequently, it is possible for an e-fuse to be constructed which fully blocks current in both directions when required.

In further embodiments, the interface of the embodiments is combined with the driver to form a drive module for the e-fuse. In embodiments, the driver is implemented as an application specific integrated circuit (ASIC), which is a design which facilitates physical handling and connection to a test environment. Particularly, configuring the driver as an ASIC leads to space and material optimisations.

In further embodiments, the drive module is combined with the e-fuse to form a test module for the test load. The test module may be arranged as an integrated module, such that interchange between different test loads at the test module is facilitated. For example, the test load need only be connected in series with the e-fuse of the test module, with the e-fuse itself, and the associated driver interface, pre-configured.

## Claims

1. An electronic fuse driver interface (50) comprising a circuit arranged to couple to the driver (20), the electronic fuse (31), and a test load (33), and comprising:
a switch (51) for selectively coupling a control input (32) of the electronic fuse to a ground of the test load; and
a resistor network (52, 53, 54) between the ground (35) of the test load and a ground of the driver (22);
wherein the switch is connected to the resistor network so as to switch the control input such that the electronic fuse blocks current between a test supply voltage (34) and the test load if the driver ground voltage is above the test load ground voltage;
the interface further comprising a diode (56) connected between an intermediate node of the resistor network and the test supply voltage to provide a path between the ground of the test load and the test supply voltage if the test supply voltage is below the ground of the test load.

2. An interface (50) according to claim 1, wherein the switch (51) is a transistor, connected between the control input (32) of the electronic fuse (31) and the test load (33).

3. An interface (50) according to claim 2, wherein the input to the transistor (51) is configured such that it is driven above a threshold voltage, if the driver ground voltage (22) is above the test load ground voltage (35), to provide a current path between the control input (32) of the electronic fuse (31) and the test load (33).

4. An interface (50) according to claim 3, wherein the input to the transistor (51) is connected to a further intermediate node of the resistor network (52, 53, 54) between the driver ground (22) and the test load ground (35).

5. An interface according to claim 4, comprising a diode (55) between the driver ground (22) and the resistor network (52, 53, 54) so as restrict current flow through the resistor network in the direction from the test load ground (35) to the driver ground.

6. A drive module for an electronic fuse, comprising:
a driver (20); and
an interface (50) of any one of claims 2 to 5,
wherein the driver comprises a complementary pair of MOSFETs (27, 28) in a push-pull transistor configuration, having a common drain connection, and a controller (23) for controlling a driver output voltage (24) at the common drain connection in dependence upon current through the electronic fuse (31),
wherein the driver output is connected to the control input (32) of the electronic fuse (31), and the collector of the switch (51) of the interface.

7. A drive module according to claim 6, wherein the driver (20) is an application-specific integrated circuit, ASIC.

8. A drive module according to claim 6 or claim 7, wherein the driver output (24) is for driving an electronic fuse (31) connected between an automotive battery supply (34) and an automotive load (33), wherein the electronic fuse ground is a chassis ground (35).

9. A test module comprising the drive module of any one of claims 6 to 8 and the electronic fuse (31), wherein the electronic fuse is a MOSFET,
wherein the control input (32) is the gate of the MOSFET, the drain of the MOSFET is connected to the test supply voltage (34), and the source of the MOSFET is connected to the test load (33).

10. A test module according to claim 9, wherein the MOSFET of the electronic fuse (31) is connected to a further MOSFET in a back-to-back configuration, and a control input of the further MOSFET is connected to the driver (20) and the switch (51) of the interface (50).

## Patentansprüche

1. Treiberschnittstelle einer elektronischen Sicherung (50), umfassend einen Schaltkreis, der so angeordnet ist, dass er den Treiber (20), die elektronische Sicherung (31) und eine Prüflast (33) koppelt, und umfassend:
einen Schalter (51) zum wahlweisen Koppeln eines Steuereingangs (32) der elektronischen Sicherung mit einer Masse der Prüflast; und
ein Widerstandsnetzwerk (52, 53, 54) zwischen der Masse (35) der Prüflast und einer Masse des Treibers (22);
wobei der Schalter mit dem Widerstandsnetzwerk verbunden ist, um den Steuereingang so zu schalten, dass die elektronische Sicherung den Strom zwischen einer Prüfversorgungsspannung (34) und der Prüflast blockiert, wenn die Massespannung des Treibers oberhalb der Massespannung der Prüflast liegt;
die Schnittstelle ferner umfassend eine Diode (56), die zwischen einem Zwischenknoten des Widerstandsnetzwerks und der Prüfversorgungsspannung verbunden ist, um einen Pfad zwischen der Masse der Prüflast und der Prüfversorgungsspannung bereitzustellen, wenn die Prüfversorgungsspannung unterhalb der Masse der Prüflast liegt.

2. Schnittstelle (50) nach Anspruch 1, wobei der Schalter (51) ein Transistor ist, der zwischen dem Steuereingang (32) der elektronischen Sicherung (31) und der Prüflast (33) verbunden ist.

3. Schnittstelle (50) nach Anspruch 2, wobei der Eingang zum Transistor (51) so konfiguriert ist, dass er oberhalb einer Schwellenspannung betrieben wird, wenn die Massespannung des Treibers (22) oberhalb der Massespannung der Prüflast (35) liegt, um einen Strompfad zwischen dem Steuereingang (32) der elektronischen Sicherung (31) und der Prüflast (33) bereitzustellen.

4. Schnittstelle (50) nach Anspruch 3, wobei der Eingang zu dem Transistor (51) mit einem weiteren Zwischenknoten des Widerstandsnetzwerks (52, 53, 54) zwischen der Treibermasse (22) und der Prüflastmasse (35) verbunden ist.

5. Schnittstelle nach Anspruch 4, umfassend eine Diode (55) zwischen der Treibermasse (22) und dem Widerstandsnetzwerk (52, 53, 54), um den Stromfluss durch das Widerstandsnetzwerk in die Richtung von der Prüflastmasse (35) zu der Treibermasse zu beschränken.

6. Treibermodul für eine elektronische Sicherung, umfassend:
einen Treiber (20); und
eine Schnittstelle (50) nach einem der Ansprüche 2 bis 5, wobei der Treiber ein komplementäres Paar von MOSFETs (27, 28) in einer Gegentakttransistor-Konfiguration umfasst, die einen gemeinsamen Drain-Anschluss aufweist, und eine Steuerung (23) für das Steuern einer Treiberausgangsspannung (24) an dem gemeinsamen Drain-Anschluss, abhängig von einem Strom durch die elektronische Sicherung (31),
wobei der Treiberausgang mit dem Steuereingang (32) der elektronischen Sicherung (31) und dem Kollektor des Schalters (51) der Schnittstelle verbunden ist.

7. Treibermodul nach Anspruch 6, wobei der Treiber (20) eine anwendungsspezifische integrierte Schaltung, ASIC, ist.

8. Treibermodul nach Anspruch 6 oder Anspruch 7, wobei der Treiberausgang (24) dem Antreiben einer elektronischen Sicherung (31) dient, die zwischen einer Automobilbatterieversorgung (34) und einer Automobillast (33) verbunden ist, wobei die Masse der elektronischen Sicherung eine Chassis-Masse (35) ist.

9. Prüfmodul, umfassend das Treibermodul nach einem der Ansprüche 6 bis 8 und die elektronische Sicherung (31), wobei die elektronische Sicherung ein MOSFET ist,
wobei der Steuereingang (32) das Gate des MOSFET ist, der Drain des MOSFET mit der Prüfversorgungsspannung (34) verbunden ist und die Quelle des MOSFET mit der Prüflast (33) verbunden ist.

10. Prüfmodul nach Anspruch 9, wobei der MOSFET der elektronischen Sicherung (31) mit einem weiteren MOSFET in einer Back-to-Back-Konfiguration verbunden ist und ein Steuereingang des weiteren MOSFET mit dem Treiber (20) und dem Schalter (51) der Schnittstelle (50) verbunden ist.

## Revendications

1. Interface de circuit de commande de fusible électronique (50) comprenant un circuit agencé de manière à être couplé au circuit de commande (20), au fusible électronique (31) et à une charge de test (33), et comprenant :
un commutateur (51) destiné à coupler de manière sélective une entrée de commande (32) du fusible électronique à une masse de la charge de test ; et
un réseau de résistances (52, 53, 54) entre la masse (35) de la charge de test et une masse du circuit de commande (22) ;
dans lequel le commutateur est connecté au réseau de résistances de manière à commuter l'entrée de commande de sorte que le fusible électronique bloque le courant entre une tension d'alimentation de test (34) et la charge de test si la tension de masse du circuit de commande est supérieure à la tension de masse de la charge de test ;
l'interface comprenant en outre une diode (56) connectée entre un nœud intermédiaire du réseau de résistances et la tension d'alimentation de test pour fournir un chemin entre la masse de la charge de test et la tension d'alimentation de test si la tension d'alimentation de test est inférieure à la masse de la charge de test.

2. Interface (50) selon la revendication 1, dans laquelle le commutateur (51) est un transistor, connecté entre l'entrée de commande (32) du fusible électronique (31) et la charge de test (33).

3. Interface (50) selon la revendication 2, dans laquelle l'entrée du transistor (51) est conçue de sorte qu'elle est commandée au-dessus d'une tension de seuil, si la tension de masse du circuit de commande (22) est supérieure à la tension de masse de la charge de test (35), pour fournir un chemin de courant entre l'entrée de commande (32) du fusible électronique (31) et la charge de test (33).

4. Interface (50) selon la revendication 3, dans laquelle l'entrée du transistor (51) est connectée à un autre nœud intermédiaire du réseau de résistances (52, 53, 54) entre la masse du circuit de commande (22) et la masse de la charge de test (35).

5. Interface selon la revendication 4, comprenant une diode (55) entre la masse du circuit de commande (22) et le réseau de résistances (52, 53, 54) de manière à limiter le flux de courant traversant le réseau de résistances dans la direction allant de la masse de la charge de test (35) à la masse du circuit de commande.

6. Module de circuit de commande destiné à un fusible électronique, comprenant :
un circuit de commande (20) ; et
une interface (50) selon l'une quelconque des revendications 2 à 5,
dans lequel le circuit de commande comprend une paire complémentaire de MOSFET (27, 28) dans une configuration de transistors push-pull, présentant une connexion de drain commune, et un dispositif de commande (23) destiné à commander une tension de sortie du circuit de commande (24) au niveau de la connexion de drain commune en fonction du courant traversant le fusible électronique (31),
dans lequel la sortie du circuit de commande est connectée à l'entrée de commande (32) du fusible électronique (31) et au collecteur du commutateur (51) de l'interface.

7. Module de circuit de commande selon la revendication 6, dans lequel le circuit de commande (20) est un circuit intégré spécifique à une application, ASIC.

8. Module de circuit de commande selon la revendication 6 ou la revendication 7, dans lequel la sortie du circuit de commande (24) est destinée à piloter un fusible électronique (31) connecté entre une alimentation de batterie d'automobile (34) et une charge d'automobile (33), dans lequel la masse du fusible électronique est une masse du châssis (35).

9. Module de test comprenant le module de circuit de commande selon l'une quelconque des revendications 6 à 8 et le fusible électronique (31), dans lequel le fusible électronique est un MOSFET,
dans lequel l'entrée de commande (32) est la grille du MOSFET, le drain du MOSFET est connecté à la tension d'alimentation de test (34), et la source du MOSFET est connectée à la charge de test (33).

10. Module de test selon la revendication 9, dans lequel le MOSFET du fusible électronique (31) est connecté à un autre MOSFET dans une configuration dos à dos, et une entrée de commande de l'autre MOSFET est connectée au circuit de commande (20) et au commutateur (51) de l'interface (50).
